# EUROPEAN PATENT APPLICATION

(11) **EP 2 063 457 A2**
(43) Date of publication of application: **27.05.2009**
(21) Application number: 08020194.0
(22) Date of filing: 19.11.2008
(51) Int. Cl.: H01L 21/205, H01L 21/20

(54) **Group III nitride semiconductor crystal growing method, group III nitride semiconductor crystal substrate fabrication method, and group III nitride semiconductor crystal substrate**

(30) Priority: 20.11.2007 JP 2007300459
(71) Applicant: Sumitomo Electric Industries, Ltd., Osaka-shi, Osaka 541-0041 (JP)
(72) Inventor: Okahisa, Takuji, Itami-shi Hyogo 664-0016 (JP); Kawase, Tomohiro, Itami-shi Hyogo 664-0016 (JP); Uemura, Tomoki, Itami-shi Hyogo 664-0016 (JP); Nishioka, Muneyuki, Itami-shi Hyogo 664-0016 (JP); Arakawa, Satoshi, Itami-shi Hyogo 664-0016 (JP)
(74) Representative: Grünecker, Kinkeldey, Stockmair & Schwanhäusser Anwaltssozietät

(57) **Abstract**

A growing method of a group III nitride semiconductor crystal includes the steps of preparing an underlying substrate (step S1), and growing a group III nitride semiconductor crystal doped with silicon by using silicon tetrafluoride gas as doping gas, on the underlying substrate by vapor phase growth (step S2).

## Description

### BACKGROUND OF THE INVENTION

### Field of the Invention

The present invention relates to a growing method of a group III nitride semiconductor crystal, a fabrication method of a group III nitride semiconductor crystal substrate, and a group III nitride semiconductor crystal substrate.

### Description of the Related Art

Group III nitride semiconductor crystals such as GaN (gallium nitride) crystals having an energy bandgap of 3.4 eV and high thermal conductivity is attracting attention as the material for semiconductor devices such as an optical device and power electronic device of short wavelength.

As a fabrication method of such a group III nitride semiconductor crystal, Japanese Patent Laying-Open No. 2003-17420 (Patent Document 1), for example, discloses growing a gallium nitride type compound semiconductor employing silane (SiH₄), disilane (Si₂H₆), trichlorosilane (SiHCl₃), dichlorosilane (SiH₂Cl₂), monochlorosilane (SiH₃Cl) and tetrachlorosilane (SiCl₄) as the raw material for doping silicon (Si) based on HVPE (Hydride Vapor Phase Epitaxy).

Furthermore, Japanese Patent Laying-Open No. 2000-91234 (Patent Document 2) discloses growing a nitride type group III-V compound semiconductor using SiHₓCl₄₋ₓ(x =1∼3) as the raw material for doping silicon based on HVPE.

In addition, Japanese Patent Laying-Open No. 3-252175 (Patent Document 3) discloses growing a gallium nitride type compound semiconductor employing silane as the raw material for doping silicon based on MOCVD (Metal Organic Chemical Vapor Deposition).

Furthermore, Japanese Patent Laying-Open No. 2005-223243 (Patent Document 4) discloses a method for growing, based on HVPE, a group III nitride semiconductor crystal doped with the silicon element included in a flow pipe formed of a material containing silicon by allowing a flow of hydrogen halide through the flow pipe onto a substrate.

In the stage of growing a group III nitride semiconductor crystal by vapor phase growth such as HVPE or MOCVD, the concentration of n type impurities (dopant) in the group III nitride semiconductor crystal must be controlled to regulate the n type conductive property of the group III nitride semiconductor crystal. The doping gas employed in the aforementioned Patent Documents 1-3 for the purpose of doping silicon qualified as the n type impurity may be decomposed before arriving at the underlying substrate due to the growth temperature of group III nitride semiconductor crystal and adhere to the reaction tube. Moreover, the doping gas may react with nitrogen gas or ammonia gas to produce an SiₓN_{y} (silicon nitride) type compound (x and y are arbitrary integers). It was difficult to control the concentration of silicon in the doping gas if the doping gas directed to supplying silicon is decomposed or reacts as set forth above prior to arrival to the underlying substrate. As a result, the concentration of silicon taken in the group III nitride semiconductor crystal will vary, so that concentration of silicon taken in the group III nitride semiconductor crystal could not be adjusted. It was therefore difficult to control the resistivity of the group III nitride semiconductor crystal based on silicon as the dopant. Particularly in the case where HVPE is employed, this problem is further noticeable since decomposition of doping gas and/or reaction with another gas was significant due to the entire heating of the reaction tube.

A possible consideration is to supply the doping gas at high rate for the purpose of preventing thermal decomposition of the doping gas or reaction with the material gas. However, the concentration distribution of the doping gas supplied to the underlying substrate will be degraded if the doping gas is supplied at high rate. Thus, there was a problem that the in-plane distribution of the resistivity is degraded.

In the aforementioned Patent Document 4, the silicon for doping into the group III nitride semiconductor crystal is generated by the reaction (corrosion) between hydrogen halide and the flow pipe taking advantage of the corrosion behavior. The concentration of silicon is reduced if the concentration of hydrogen halide to the carrier gas is reduced or if the temperature of hydrogen halide becomes high. The concentration of silicon will also vary when the surface state of the flow pipe is altered by the reaction with hydrogen halide. Thus, the amount of silicon taken in the group III nitride semiconductor crystal will vary due to the reduction or change of the silicon concentration. As a result, it was difficult to control the resistivity of the obtained group III nitride semiconductor crystal.

### SUMMARY OF THE INVENTION

In view of the foregoing, an object of the present invention is to provide a group III nitride semiconductor crystal growing method, a group III nitride semiconductor crystal substrate fabrication method, and a group III nitride semiconductor crystal substrate, allowing the resistivity to be readily controlled and preventing degradation in the resistivity in-plane distribution.

A growing method of a group III nitride semiconductor crystal of the present invention includes the steps set forth below. First, an underlying substrate is prepared. Then, a first group III nitride semiconductor crystal doped with silicon by using silicon tetrafluoride (SiF₄) as doping gas is grown on the underlying substrate by vapor phase growth.

By the growing method of a group III nitride semiconductor crystal of the present invention, silicon tetrafluoride gas is employed as doping gas in growing the first group III nitride semiconductor crystal doped with silicon. Silicon tetrafluoride gas is characterized in that, as compared to other doping gases directed to doping silicon, the gas per se is not readily decomposed, and does not easily react with another gas such as the raw material gas for the group III nitride semiconductor crystal and the carrier gas. Therefore, the event of the silicon tetrafluoride gas being decomposed prior to arrival at the underlying substrate to adhere to a region other than the underlying substrate and/or a compound being generated by the reaction of silicon in the silicon tetrafluoride gas can be suppressed. Accordingly, control of the concentration of silicon qualified as the dopant is facilitated by adjusting the concentration of the silicon tetrafluoride gas that is the doping gas. As a result, the concentration of silicon taken in the first group III nitride semiconductor crystal can be regulated at a constant level. Thus, the resistivity of the group III nitride semiconductor crystal can be readily controlled.

Since the concentration of silicon in the silicon tetrafluoride gas can be readily controlled, it is not necessary to supply the silicon tetrafluoride gas to the underlying substrate at high rate. Accordingly, the first group III nitride semiconductor crystal can be grown with the doping gas supplied at an appropriate rate, and the doping gas can be supplied uniformly to the underlying substrate. Therefore, degradation in the in-plane distribution of the resistivity of the first group III nitride semiconductor crystal grown can be prevented.

Preferably in the growing method of a group III nitride semiconductor crystal set forth above, the growing step includes the step of growing a first group III nitride semiconductor crystal by hydride vapor phase epitaxy (HVPE).

Since the HVPE is based on growing a group III nitride semiconductor crystal under a state where the entire reaction pipe is heated, a high temperature environment facilitating decomposition of the doping gas will be achieved. The silicon tetrafluoride gas is characterized in that decomposition as well as reaction with another gas is suppressed even in such an environment. Therefore, the silicon tetrafluoride gas is conveniently employed in HVPE.

Preferably in the growing method of a group III nitride semiconductor crystal set forth above, the growing step includes the step of growing the first group III nitride semiconductor crystal at a temperature of at least 900°C and not more than 1300°C.

The temperature of at least 900°C allows the generation of a defect in the growing first group III nitride semiconductor crystal to be prevented, and suppresses the generation at another plane orientation. The temperature of not more than 1300°C allows decomposition of the growing first group III nitride semiconductor crystal to be suppressed. Therefore, degradation in the crystallinity can be suppressed.

Preferably in the growing method of a group III nitride semiconductor crystal set forth above, the growing step includes the step of supplying the doping gas to the underlying substrate such that the concentration of silicon in the first group III nitride semiconductor crystal is at least 5 × 10¹⁶cm⁻³ and not more than 5 × 10²⁰cm⁻³, more preferably at least 3 × 10¹⁸cm⁻³ and not more than 5 × 10¹⁹cm⁻³.

In the case where the silicon concentration is at least 5 × 10¹⁶cm⁻³, the concentration of silicon taken in the first group III nitride semiconductor crystal can be controlled readily. In the case where the silicon concentration is at least 3 × 10¹⁸cm⁻³, the concentration of silicon taken in can be controlled more readily. In the case where the silicon concentration is not more than 5 × 10²⁰cm⁻³, fragility due to the silicon being taken in as impurities during the growth of a group III nitride semiconductor crystal can be suppressed. Thus, a first group III nitride semiconductor crystal having generation of a pit or defect as well as a crack suppressed can be grown. In the case where the concentration of silicon is not more than 5 × 10¹⁹cm⁻³, a first group III nitride semiconductor crystal of more favorable crystallinity can be grown.

Preferably in the growing method of a group III nitride semiconductor crystal set forth above, the growing step includes the step of growing a first group III nitride semiconductor crystal such that the resistivity is at least 1 × 10⁻⁴ Ω·cm and not more than 0.1 Ω·cm.

In the case where the resistivity is at least 1 × 10⁻⁴ Ω·cm, silicon does not have to be doped in high concentration. Therefore, the generation of a pit or defect, as well as a crack during the growth of a group III nitride semiconductor crystal can be suppressed. In the case where the resistivity is not more than 0.1 Ω·cm, the group III nitride semiconductor crystal is conveniently selected for an n type substrate employed in an electronic device or light-emitting device.

Preferably in the growing method of a group III nitride semiconductor crystal set forth above, the preparing step includes the step of preparing an underlying substrate formed of a material including at least one type selected from the group consisting of silicon (Si), sapphire (Al₂O₃), gallium arsenide (GaAs), silicon carbide (SiC), gallium nitride (GaN) and aluminium nitride (AlN). Preferably in the growing method of a group III nitride semiconductor crystal set forth above, a spinel type crystal substrate is prepared as the underlying substrate. Accordingly, a group III nitride semiconductor crystal of favorable crystallinity can be grown on the underlying substrate.

Preferably in the growing method of a group III nitride semiconductor crystal set forth above, the first group III nitride semiconductor crystal is an AlₓIn_{y}Ga_{(1-x-y)}N (0≤ x ≤1, 0≤y≤1,x+y≤1) crystal. Preferably in the growing method of a group III nitride semiconductor crystal set forth above, the first group III nitride semiconductor crystal is a gallium nitride crystal. Accordingly, an extremely effective first group III nitride semiconductor crystal can be grown.

Preferably in the growing method of a group III nitride semiconductor crystal set forth above, the growing step includes the step of supplying the doping gas to the underlying substrate such that the concentration of oxygen in the first group III nitride semiconductor crystal is not more than 5 × 10¹⁶ cm⁻³.

In the case where the concentration of oxygen is not more than 5 × 10¹⁶ cm⁻³, the resistivity of the growing first group III nitride semiconductor crystal can be controlled more stably.

Preferably in the growing method of a group III nitride semiconductor crystal set forth above, there is further provided the step of growing a second group III nitride semiconductor crystal doped with silicon by using silicon tetrafluoride as the doping gas, on the first group III nitride semiconductor crystal.

Accordingly, the first group III nitride semiconductor crystal can be employed for a buffer layer directed to alignment with the underlying substrate as to the lattice constant. Therefore, a second group III nitride semiconductor crystal of more favorable crystallinity can be grown.

A fabrication method of a group III nitride semiconductor crystal substrate of the present invention includes the steps set forth below. First, a group III nitride semiconductor crystal is grown on an underlying substrate by the growing method of a group III nitride semiconductor crystal set forth above. Then, at least the underlying substrate is removed to form a group III nitride semiconductor crystal substrate constituted of a group III nitride semiconductor crystal having a thickness of at least 100 µm.

By the fabrication method of a group III nitride semiconductor crystal of the present invention, a group III nitride semiconductor crystal substrate is fabricated, formed of the group III nitride semiconductor crystal having the resistivity controlled and degradation in the in-plane distribution prevented. Thus, a group III nitride semiconductor crystal substrate of low resistivity and having degradation in the in-plane distribution prevented can be obtained.

Preferably the fabrication method of a group III nitride semiconductor crystal substrate further includes the step of slicing the group III nitride semiconductor crystal in a thickness direction to form a plurality of group III nitride semiconductor crystal substrates constituted of the group III nitride semiconductor crystal having a thickness of at least 100 µm and not more than 1000 µm.

In the case where the thickness is at least 100 µm, generation of a crack in the obtained group III nitride semiconductor crystal substrate during handling can be prevented. A thickness of not more than 1000 µm satisfies the required thickness to be conveniently selected for a device, and can reduce the fabrication cost per one group III nitride semiconductor crystal substrate.

The group III nitride semiconductor crystal substrate of the present invention is fabricated by the above-described fabrication method of a group III nitride semiconductor crystal, and is a group III nitride semiconductor crystal substrate having a diameter of at least 25 mm and not more than 160 mm. The resistivity of the group III nitride semiconductor crystal substrate is at least 1 × 10⁻⁴Ω·cm and not more than 0.1 Ω·cm. The resistivity distribution in the diameter direction of the group III nitride semiconductor crystal substrate is at least -20% and not more than 20%. The resistivity distribution in the thickness direction of the group III nitride semiconductor crystal substrate is at least -10% and not more than 10%.

Since the group III nitride semiconductor crystal substrate of the present invention is fabricated by the fabrication method of a group III nitride semiconductor crystal substrate set forth above, there can be obtained a group III nitride semiconductor crystal substrate having the resistivity regulated to the range set forth above and having degradation in the in-plane distribution prevented to the range set forth above. Since silicon does not have to be doped in high concentration in the case where the resistivity is at least 1 × 10⁻⁴Ω·cm, generation of a pit or defect as well as a crack during growth of a group III nitride semiconductor crystal can be suppressed. In the case where the resistivity is not more than 0.1 Ω·cm, the substrate is conveniently selected as an n type substrate employed in an electronic device or light-emitting device.

The range from -20% to 20% for the resistivity distribution in the diameter direction and the range from-10% to 10% for the resistivity distribution in the thickness direction of the group III nitride semiconductor crystal substrate is advantageous in that, when devices are produced using this group III nitride semiconductor crystal substrate, variation of performance can be suppressed and the yield improved.

In the case where the diameter is at least 25 mm, generation at a different plane orientation in the growing plane can be suppressed. Therefore, a group III nitride semiconductor crystal substrate of favorable crystallinity can be obtained. Since an underlying substrate having a diameter of not more than 160 mm is readily available, a nitride semiconductor crystal substrate having a diameter of not more than 160 mm can be obtained readily.

The group III nitride semiconductor crystal substrate set forth above preferably has a thickness of at least 2 mm and not more than 160 mm.

In the case where the thickness is at least 2 mm, a plurality of group III nitride semiconductor crystal substrates having a desired thickness can be obtained by slicing the group III nitride semiconductor crystal substrate into the required thickness. In the case where the thickness is not more than 160 mm, a group III nitride semiconductor crystal can be grown readily in terms of facilities. Therefore, the cost can be reduced.

The group III nitride semiconductor crystal substrate set forth above preferably has a thickness of at least 100 µm and not more than 1000 µm.

In the case where the thickness is at least 100 µm, a group III nitride semiconductor crystal substrate having generation of a crack during handling suppressed can be obtained. In the case where the thickness is not more than 1000 µm, the substrate is conveniently employed for a device. Thus, the fabrication cost per one group III nitride semiconductor crystal substrate can be reduced.

The group III nitride semiconductor crystal substrate preferably has a resistivity of at least 1 × 10⁻³Ω·cm and not more than 8 × 10⁻³ Ω·cm.

In the case where the resistivity is at least 1 × 10⁻³ Ω·cm, it is not necessary to dope silicon in high concentration. Therefore, generation of a pit or defect as well as a crack during growth of a group III nitride semiconductor crystal can be suppressed. In the case where the resistivity is not more than 8 × 10⁻³ Ω·cm, the substrate is conveniently selected as an n type substrate employed in an electronic device or light-emitting device.

In the group III nitride semiconductor crystal substrate set forth above , the concentration of silicon is at least 5 × 10¹⁶cm⁻³ and not more than 5 × 10²⁰cm⁻³, more preferably at least 3 × 10¹⁸cm⁻³ and not more than 5 × 10¹⁹cm⁻³.

In the case where the concentration of silicon is at least 5 × 10¹⁶cm⁻³, the concentration of silicon taken in can be controlled readily. In the case where the concentration of silicon is at least 3 × 10¹⁸cm⁻³, the concentration of silicon taken in can be controlled more readily. In the case where the silicon concentration is not more than 5 × 10²⁰cm⁻³, generation of a pit or defect as well as a crack during growth of a group III nitride semiconductor crystal can be suppressed. In the case where the silicon concentration is not more than 5 ×10¹⁹cm⁻³, a group III nitride semiconductor crystal substrate of favorable crystallinity can be obtained.

The group III nitride semiconductor crystal substrate set forth above preferably has a dislocation density of not more than 1 × 10⁷cm⁻².

By employing the group III nitride semiconductor crystal substrate in a semiconductor device such as an electronic device or light-emitting device, properties such as the electric property and optical property can be stabilized.

Preferably in the group III nitride semiconductor crystal substrate set forth above, the main face has an angle of at least -5 degrees and not more than 5 degrees relative to any one of a (0001) plane, (1-100) plane, (11-20) plane and (11-22) plane.

Accordingly, a group III nitride semiconductor crystal of favorable crystallinity can be further grown on the main face. Thus, a semiconductor device of more favorable property can be obtained.

In the group III nitride semiconductor crystal substrate set forth above , the full width at half maximum (FWHM) of the rocking curve in X-ray diffraction is at least 10 arcsec and not more than 500 arcsec.

Accordingly, a group III nitride semiconductor crystal of favorable crystallinity can be additionally grown on the group III nitride semiconductor crystal substrate. Therefore, a semiconductor device of more favorable property can be obtained.

In the present invention, "group III" implies group IIIB in the former IUPAC (The International Union of Pure and Applied Chemistry) system. Namely, a group III nitride semiconductor crystal implies a semiconductor crystal including nitrogen, and at least one element of boron (B), aluminium (Al), gallium (Ga), indium (In) and thallium (Tl). "Doping gas" implies gas used to dope impurities (dopant).

According to a growing method of a group III nitride semiconductor crystal of the present invention, there can be grown a group III nitride semiconductor crystal, allowing the resistivity to be readily controlled and preventing degradation in the resistivity in-plane distribution.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a schematic perspective view of a gallium nitride crystal substrate according to a first embodiment of the present invention.
Fig. 2 is a schematic top view of a gallium nitride crystal substrate of the first embodiment.
Fig. 3 is a flowchart of a fabrication method of a group III nitride semiconductor crystal substrate of the first embodiment.
Fig. 4 is a schematic view representing a state of growing a group III nitride semiconductor crystal in the first embodiment.
Fig. 5 is a schematic view of an HVPE apparatus employed in a growing method of a group III nitride semiconductor crystal of the first embodiment.
Fig. 6 is a schematic diagram of a group III nitride semiconductor crystal representing a state of at least the underlying substrate removed in the first embodiment.
Fig. 7 is a schematic diagram of a grown state of a group III nitride semiconductor crystal according to a first modification of the first embodiment.
Fig. 8 is a schematic diagram of a group III nitride semiconductor crystal representing a state of at least the underlying substrate removed in the first modification of the first embodiment.
Fig. 9 is a schematic diagram of a group III nitride semiconductor crystal representing a state of at least the underlying substrate removed in a second modification of the first embodiment.
Fig. 10 is a schematic perspective view of a group III nitride semiconductor crystal substrate according to a second embodiment of the present invention.
Fig. 11 is a flowchart of a fabrication method of a group III nitride semiconductor crystal substrate of the second embodiment.
Fig. 12 is a schematic diagram of a group III nitride semiconductor crystal substrate representing a slicing state of the second embodiment.
Fig. 13 is a schematic diagram of a fabrication method of a group III nitride semiconductor crystal substrate according to a modification of the second embodiment.
Fig. 14 represents the relationship between the partial pressure of silicon tetrafluoride gas to the resistivity and silicon concentration.

### DESCRIPTION OF THE PREFERRED EMBODIMENTS

Embodiments of the present invention will be described hereinafter with reference to the drawings. In the drawings, the same or corresponding elements have the same reference characters allotted, and description thereof will not be repeated.

### First Embodiment

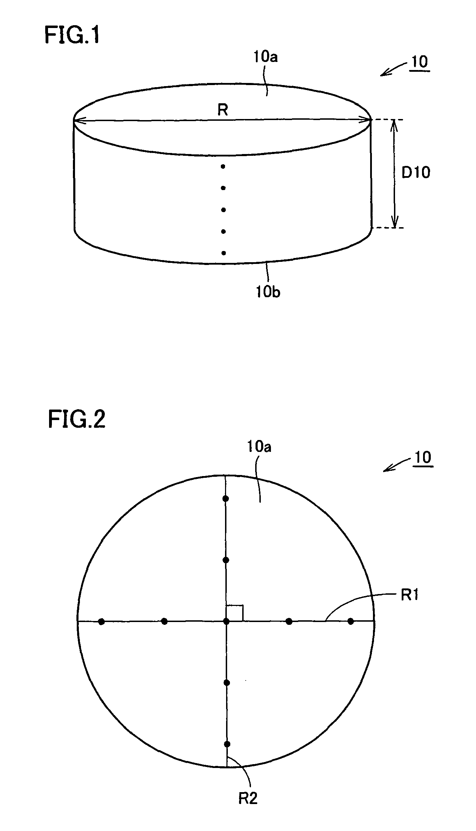

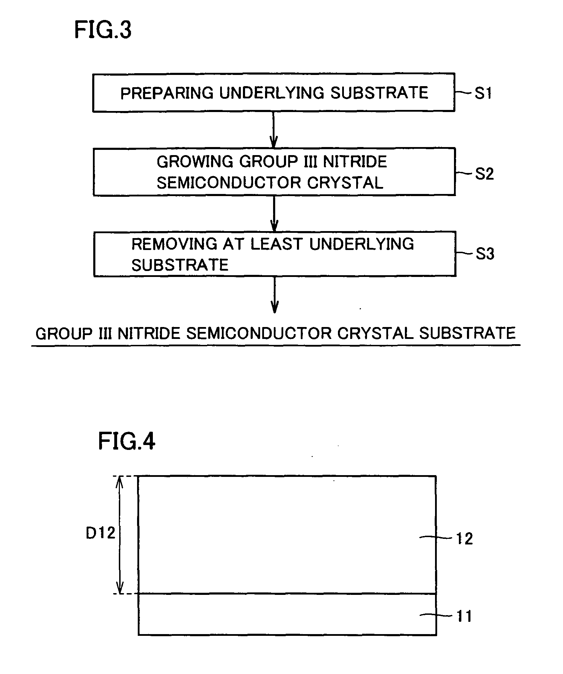

A group III nitride semiconductor crystal substrate according to an embodiment of the present invention will be described hereinafter with reference to Figs. 1 and 2. As shown in Figs. 1 and 2, a group III nitride semiconductor crystal substrate 10 is formed of a group III nitride semiconductor crystal 12 (refer to Fig. 4) having silicon doped as the impurity. Group III nitride semiconductor crystal substrate 10 includes a main face 10a.

As shown in Figs. 1 and 2, a group III nitride semiconductor crystal substrate 10 of the present embodiment has a diameter R that is at least 25 mm and not more than 160 mm, preferably at least 45 mm and not more than 130 mm. A diameter R of at least 25 mm is advantageous in that the crystallinity of group III nitride semiconductor crystal substrate 10 is rendered favorable since the occurrence of a different plane orientation at main face 10a is prevented. In the case where diameter R is at least 45 mm, the crystallinity of group III nitride semiconductor crystal substrate 10 is rendered more favorable. A diameter R of 160 mm is advantageous in that the cost can be reduced since the underlying substrate is readily available. In the case where diameter R is not more than 130 mm, the cost can be further reduced.

Group III nitride semiconductor crystal substrate 10 has a thickness D 10 of at least 2 mm and not more than 160 mm, preferably at least 6 mm and not more than 50 mm. In the case where D10 is at least 2 mm, a plurality of group III nitride semiconductor crystal substrates having a desired thickness can be obtained by slicing group III nitride semiconductor crystal substrate 10 to the desired thickness. A thickness D10 of at least 6 mm is advantageous in that more group III nitride semiconductor crystal substrates of a desired thickness can be obtained from one group III nitride semiconductor crystal substrate 10, leading to reduction in cost. In the case where thickness D10 is not more than 160 mm, a group III nitride semiconductor crystal can be grown readily in terms of facilities. Therefore, the cost can be reduced. In the case where thickness D10 is at least 50 mm, the cost can be further reduced.

The resistivity of group III nitride semiconductor crystal substrate 10 is at least 1 × 10⁻⁴ Ω·cm and not more than 0.1 Ω·cm, preferably at least 1 × 10⁻³ Ω·cm and not more than 1 × 10⁻² Ω·cm, more preferably at least 1 × 10⁻³ Ω·cm and not more than 8 x 10⁻³ Ω·cm. The resistivity of at least 1 × 10⁻⁴ Ω·cm is at advantageous in that silicon does not have to be doped in high concentration. Therefore, the generation of a pit or defect, as well as a crack during growth of a group III nitride semiconductor crystal can be suppressed. In the case where the resistivity is at least 1 × 10⁻³ Ω·cm, the generation of a pit, defect, and crack can be further suppressed. In the case where the resistivity is not more than 0.1 Ω·cm, the substrate is conveniently employed in light emitting devices and electronic devices. In the case where the resistivity is not more than 1 × 10⁻² Ω·cm, the substrate is further conveniently selected as an n type substrate used in light emitting devices and optical devices, particularly power devices. In the case where the resistivity is not more than 8 × 10⁻³ Ω·cm, the substrate is more further conveniently selected as an n type substrate used in light emitting devices and optical devices, particularly power devices.

As used herein, "resistivity" is a value measured by the method set forth below. First, main face 10a of group III nitride semiconductor crystal substrate 10 is subjected to polishing and dry etching. Then, the resistivity is measured at each site of the total of 9 points such as the nine dots shown in Fig. 2, i.e. 5 points along an arbitrary diameter R1, including one point around the center, two points around either ends, and respective intermediate points between the center and either end (two points), and 4 points along a diameter R2 orthogonal to diameter R1, including two points around either ends and respective intermediate points between the center and either end (two points), by the four probe method at room temperature. Then, the average value of the resistivity at these nine points is calculated. Although a method of measuring the resistivity with respect to main face 10a has been described, the resistivity may be measured for another face. For example, a face parallel to main face 10a is obtained by slicing substantially the middle plane in the thickness direction between main face 10a and a face 10b opposite surface to main face 10a. Then, the resistivity at the nine points on the obtained face is measured in a similar manner, from which the resistivity average value can be calculated. Alternatively, the resistivity of nine points on a face orthogonal to main face 10a may be measured, from which the resistivity average value can be calculated.

The resistivity distribution in the diameter direction of group III nitride semiconductor crystal substrate 10 is at least -20% and not more than 20%, preferably at least -5% and not more than 5%. The range of-20% to 20% is advantageous in that, when devices are produced using group III nitride semiconductor crystal substrate 10, variation of the performance in the diameter direction is suppressed and the yield can be improved. The range of-5% to 5% is advantageous in that, when devices are produced using the substrate, variation of the performance is suppressed and the yield can be improved.

As used herein, " resistivity distribution in the diameter direction" refers to a value measured by a method set forth below. First, main face 10a of group III nitride semiconductor crystal substrate 10 is subjected to polishing and dry etching. Then, the resistivity is measured at each site of the total of 9 points such as the nine dots shown in Fig. 2, i.e. 5 points along an arbitrary diameter R1 including one point around the center, two points around either ends, and respective intermediate points between the center and either end (two points), and 4 points along a diameter R2 orthogonal to diameter R1, including two points around either ends and respective intermediate points between the center and either end (two points), by the four probe method at room temperature. Then, the average value of the resistivity at these nine points is calculated. With regards to the values of resistivity at the nine points, the value defined by (largest value - average value)/average value is taken as the upper limit of the resistivity distribution in the diameter direction, and the value defined by (smallest value - average value)/average value is taken as the lower limit of the resistivity distribution in the diameter direction. Although a method of measuring the resistivity with respect to main face 10a has been described, the resistivity may be measured for another face.

The resistivity distribution in the thickness direction of group III nitride semiconductor crystal substrate 10 is at least -10% and not more than 10%, preferably at least-3% and not more than 3%. The range of-10% to 10% is advantageous in that, when devices are produced using this group III nitride semiconductor crystal substrate, variation of the performance in the thickness direction can be suppressed and the yield improved. The range of -3% to 3% is advantageous in that, when devices are produced using the substrate, variation of the performance is suppressed and the yield improved.

As used herein, " resistivity distribution in the thickness direction" refers to a value measured by a method set forth below. First, main face 10a of group III nitride semiconductor crystal substrate 10 is subjected to polishing and dry etching. Then, the resistivity is measured at each site of the total of 5 points at respective arbitrary thickness such as the five dots shown in Fig. 1, i.e. one point in the proximity of main face 10a, one point in the proximity of a face 10b opposite to main face 10a, and 3 points between main face 10a and opposite face 10b, by the four probe method at room temperature. The average of the 5 values of resistivity is calculated. With regards to the values of resistivity at the five points, the value defined by (largest value - average value)/average value is taken as the upper limit of the resistivity distribution in the thickness direction, and the value defined by (smallest value - average value)/average value is taken as the lower limit of the resistivity distribution in the thickness direction.

The concentration of silicon in group III nitride semiconductor crystal 12 is preferably at least 5 × 10¹⁶cm⁻³ and not more than 5 × 10²⁰cm⁻³, more preferably at least 3 × 10¹⁸ cm⁻³ and not more than 5 × 10¹⁹cm⁻³. In the case where the silicon concentration is at least 5 × 10¹⁶cm⁻³, the concentration of the silicon taken in can be readily controlled since silicon is introduced effectively. Therefore, a group III nitride semiconductor crystal substrate 10 containing silicon of high concentration can be obtained. In the case where the silicon concentration is at least 3 × 10¹⁸cm⁻³, the concentration of silicon taken in can be controlled more readily. In the case where the silicon concentration is not more than 5 × 10²⁰cm⁻³, generation of a pit or defect as well as a crack during growth of a group III nitride semiconductor crystal can be suppressed. In the case where the silicon concentration is not more than 5 × 10¹⁹cm⁻³, the crystallinity is rendered further favorable.

As used herein, "silicon concentration" refers to a value measured by a method set forth below. First, main face 10a of group III nitride semiconductor crystal substrate 10 is subjected to polishing and dry etching. Then, the silicon concentration is measured at each site of the total of 9 points such as the nine dots shown in Fig. 2, i.e. 5 points along an arbitrary diameter R1 including one point around the center, two points around either ends, and respective intermediate points between the center and either end (two points), and 4 points along a diameter R2 orthogonal to diameter R1, including two points around either ends and respective intermediate points between the center and either end (two points), by SIMS (Secondary Ion-microprobe Mass Spectrometer) at room temperature. Then, the average value of the silicon concentration at the nine points is calculated. Although a method of measuring the silicon concentration with respect to main face 10a has been described, the silicon concentration may be measured at nine points in another face, or at arbitrary 9 points based on a combination of two or more faces.

The dislocation density of group III nitride semiconductor crystal substrate 10 is preferably not more than 1 × 10⁷cm⁻², more preferably not more than 1 × 10⁶cm⁻². A dislocation density of not more than 1 × 10⁷cm⁻² is advantageous in that, when group III nitride semiconductor crystal substrate 10 is employed in an electronic device, the electric property can be improved, and when group III nitride semiconductor crystal substrate 10 is employed in an optical device, the optical property can be improved. A semiconductor device of more favorable property can be obtained. In the case where the dislocation density is not more than 1 × 10⁶cm⁻², the performance in usage of a semiconductor device can be further improved. Although the dislocation density is preferably as low as possible, the lower limit is, for example, at least 1 × 10³cm⁻². In the case where the dislocation density is at least 1 × 10³cm⁻², group III nitride semiconductor crystal substrate 10 can be produced at low cost.

As used herein, "dislocation density" is the etch pit density obtained from the number of etch pits counted on an etched surface of the nitride semiconductor crystal that has been immersed in a KOH-NaOH (potassium hydroxide-sodium hydroxide) mixture melt of 350 °C, using the Nomarski microscope or a scanning electron microscope (SEM).

The concentration of oxygen in group III nitride semiconductor crystal substrate 10 is not more than 5 × 10¹⁶cm⁻³, preferably not more than 2 × 10¹⁶cm⁻³. Although gas containing oxygen is not employed as doping gas in the present embodiment, the oxygen in the reaction tube will be taken into the growing group III nitride semiconductor crystal as a dopant. Although oxygen is an n type dopant, identical to silicon, the efficiency of being taken into the c-plane is poor. Particularly, the introduction efficiency differs depending upon the plane orientation. Oxygen is known to have poor controllability as an n type dopant. By preventing the introduction of oxygen down to the concentration of not more than 5 × 10¹⁶cm⁻³, silicon will become dominant in terms of the n type carrier concentration. Therefore, control over the silicon concentration allows the carrier concentration of group III nitride semiconductor crystal 12 to be controlled. The crystallinity can be rendered further favorable by setting the oxygen concentration to preferably not more than 2 × 10¹⁶cm⁻³. Although the oxygen concentration is preferably as low as possible, the lower limit is 5 × 10¹⁵cm⁻³ or above in consideration of the lowest measurable level for detection in SIMS analysis.

Main face 10a of group III nitride semiconductor crystal substrate 10 is preferably at the angle of at least -5 degrees and not more than 5 degrees relative to any one of a (0001) plane, (1-100) plane, (11-20) plane and (11-22) plane. A group III nitride semiconductor crystal of favorable crystallinity can be additionally grown on such a main face 10a. Therefore, the usage thereof in an electronic device and a light emitting device allows improvement in the electric property and optical property, respectively. A semiconductor device of further favorable property can be obtained.

Each individual plane is represented by ( ). Moreover, although it is crystallographically defined to attach "-" (bar sign) above the numeral for a negative index, the negative sign is attached in front of a numeral in the present specification.

The full width at half maximum of the rocking curve in the X-ray diffraction of group III nitride semiconductor crystal substrate 10 is preferably at least 10 arcsec and not more than 500 arcsec, preferably at least 20 arcsec and not more than 100 arcsec. The value of not more than 500 arcsec is advantageous in that a semiconductor device of further favorable property is obtained since a group III nitride semiconductor crystal of favorable crystallinity can be further grown on main face 10a of group III nitride semiconductor crystal substrate 10. In the case where the value is not more than 100 arcsec, a group III nitride semiconductor crystal of further favorable crystallinity can be additionally grown on main face 10a. In the case where the value is at least 10 arcsec, the cost can be reduced since a group III nitride semiconductor crystal constituting group III nitride semiconductor crystal substrate 10 can be readily grown. The cost can be further reduced in the case where the value is at least 20 arcsec.

As used herein, "full width at half maximum of a rocking curve" implies a measured value of the full width at half maximum of a rocking curve at the (0004) plane by XRD (X-ray diffraction), and becomes an index representing the in-plane orientation. The lower value of the full width at half maximum of a rocking curve, the higher favorable crystallinity.

The group III nitride semiconductor crystal constituting a group III nitride semiconductor crystal substrate 10 is preferably an AlₓIn_{y}Ga_{(1-x-y)}N (0≤x≤1, 0≤y≤ 1, x + y≤ 1) crystal, more preferably a gallium nitride crystal.

A fabrication method of a group III nitride semiconductor crystal substrate of the present embodiment will be described with reference to Figs. 3 and 4. First, a growing method of a group III nitride semiconductor crystal constituting a group III nitride semiconductor crystal substrate will be described.

As shown in Figs. 3 and 4, an underlying substrate 11 is prepared (step S1). Underlying substrate 11 is a substrate directed to growing group III nitride semiconductor crystal 12 thereon.

At the preparing step (step S1), underlying substrate 11 preferably formed of a material including at least one type selected from the group consisting of silicon, sapphire, gallium arsenide, silicon carbide, gallium nitride, and aluminium nitride is prepared. Alternatively, a spinel type crystal substrate such as MgAl₂O₄ is preferably prepared as underlying substrate 11. Moreover, in order to reduce the difference in lattice constant, underlying substrate 11 is preferably formed of a composition identical to that of group III nitride semiconductor crystal 12 to be grown.

The prepared underlying substrate 11 has a diameter of at least 25 mm and not more than 160 mm, preferably at least 45 mm and not more than 130 mm. Underlying substrate 11 having a diameter of at least 25 mm is advantageous in that group III nitride semiconductor crystal 12 of favorable crystallinity can be grown since growing a group III nitride semiconductor crystal 12 on a plane of a different plane orientation can be prevented. In the case where the diameter of underlying substrate 11 is at least 45 mm, group III nitride semiconductor crystal 12 of further favorable crystallinity can be grown. In the case where the diameter of underlying substrate 11 is not more than 160 mm, the cost can be reduced since it is available readily. In the case where the diameter of underlying substrate 11 is not more than 130 mm, the cost can be further reduced.

Then, a group III nitride semiconductor crystal 12 doped with silicon using silicon tetrafluoride as the doping gas is grown on underlying substrate 11 by vapor phase growth (step S2). In the present embodiment, silicon tetrafluoride gas alone is employed for the doping gas.

The growing method is not particularly limited as long as it corresponds to vapor phase growth. For example, HVPE, MOCVD, MBE (Molecular Beam Epitaxy), or the like can be employed to grow group III nitride semiconductor crystal 12. In the present embodiment, group III nitride semiconductor crystal 12 is grown by HVPE.
By virtue of the high crystal growth rate, HVPE is advantageous in that a group III nitride semiconductor crystal 12 of great thickness D12 can be grown by controlling the growing time.

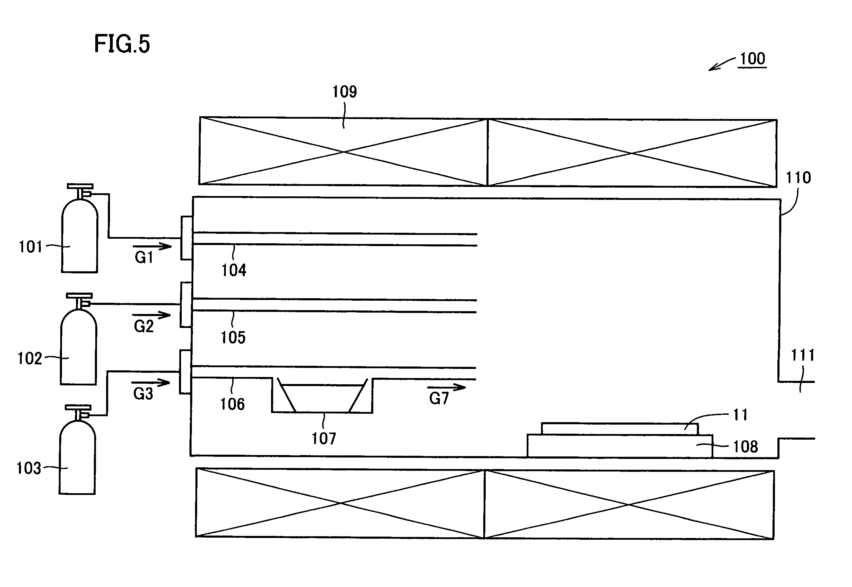

An HVPE apparatus 100 employed in the growing method of a group III nitride semiconductor crystal in the present embodiment will be described with reference to Fig. 5. As shown in Fig. 5, HVPE apparatus 100 includes a first raw material gas cylinder 101, a doping gas cylinder 102, a second raw material gas cylinder 103, a first gas introduction pipe 104, a doping gas introduction pipe 105, a second gas introduction pipe 106, a source boat 107, a susceptor 108, a heater 109, a reaction tube 110, an exhaust pipe 111, and an exhaust gas treatment device. HVPE apparatus 100 is based on a horizontal type reaction tube, for example. Alternatively, HVPE apparatus 100 may be a vertical type reaction tube.

Reaction tube 110 is a vessel to hold underlying substrate 11 therein and grow a group III nitride semiconductor crystal on underlying substrate 11. A quartz reaction tube, for example, may be employed for reaction tube 110. Raw material containing an element constituting a group III nitride semiconductor crystal to be grown is supplied to each of first raw material gas cylinder 101, second raw material gas cylinder 103 and source boat 107. Doping gas cylinder 102 is filled with silicon tetrafluoride gas as the gas containing silicon qualified as the dopant. First gas introduction pipe 104, doping gas introduction pipe 105, and second gas introduction pipe 106 are provided at reaction tube 110 to introduce first raw material gas G1, doping gas G2, and second raw material gas G3, respectively, from outside reaction tube 110. Source boat 107 stores and holds a metal raw material of the group III nitride semiconductor crystal, and is disposed in second gas introduction pipe 106.

Susceptor 108 holds underlying substrate 11. In reaction tube 110, susceptor 108 is disposed such that the face on which underlying substrate 11 is held is located below first gas introduction pipe 104, doping gas introduction pipe 105 and second gas introduction pipe 106. Susceptor 108 is disposed horizontally in reaction tube 110. Alternatively, susceptor 108 may be configured with underlying substrate 11 disposed vertically. HVPE apparatus 100 may further include a local heating mechanism such as a resistance heater for underlying substrate 11.

A heater 109 is disposed outside reaction tube 110, capable of heating the entire interior of reaction tube 110 to at least 700°C and not more than 1500°C, for example. Exhaust pipe 111 is provided at reaction tube 110 to output the gas subsequent to reaction outside of reaction tube 110. The exhaust gas treatment device is configured to allow disposal of the gas subsequent to reaction from exhaust pipe 111 so as to reduce environmental load.

In the growing step (step S2), the prepared underlying substrate 11 is held on susceptor 108, as shown in Fig. 5. At this stage, a plurality of underlying substrates 11 may be held on susceptor 108.

First and second raw material gas cylinders 101 and 103 filled with first and second raw material gasses, respectively, are prepared. In addition, the metal raw material is supplied to source boat 107. The first raw material gas, second raw material gas and metal raw material are the raw material for a group III nitride semiconductor crystal 12 to be grown. When group III nitride semiconductor crystal 12 to be grown is gallium nitride, ammonia (NH₃) gas, hydrogen chloride (HCl) gas, and gallium (Ga) may be employed for the first raw material gas, second raw material gas, and the metal raw material supplied to source boat 107, respectively. Further, a doping gas cylinder 102 filled with silicon tetrafluoride is prepared.

Then, source boat 107 is heated. Reaction gas G7 is generated by the reaction of second raw material gas G3 from second gas introduction pipe 106 with the raw material at source boat 107. First raw material gas G1 from first gas introduction pipe 104, doping gas G2, and reaction gas G7 are delivered (supplied) to strike the surface of underlying substrate 11 for reaction. At this stage, a carrier gas to carry these gases to underlying substrate 11 may be employed. Inert gas such as nitrogen (N₂) gas, hydrogen (H₂) gas and argon (Ar) gas may be employed for the carrier gas.

According to HVPE, the interior of reaction tube 110 is heated by means of heater 109 to a temperature that allows group III nitride semiconductor crystal 12 to be grown at an appropriate rate. The temperature for growing group III nitride semiconductor crystal 12 is preferably at least 900°C and not more than 1300°C, more preferably at least 1050 °C and not more than 1200°C. In the case where group III nitride semiconductor crystal 12 is grown at the temperature of 900°C or higher, generation of a defect at group III nitride semiconductor crystal 12 can be prevented. In addition, development of a plane orientation different from the plane orientation for growth (for example, a pit or the like in the case of a c-plane) can be suppressed. Namely, a group III nitride semiconductor crystal 12 of favorable crystallinity can be grown stably with respect to the plane orientation of growth. In the case where group III nitride semiconductor crystal 12 is grown at the temperature of 1050°C or higher, the crystallinity can be rendered more favorable. In the case where group III nitride semiconductor crystal 12 is grown at the temperature of 1300°C or lower, degradation in crystallinity can be suppressed since decomposition of the growing group III nitride semiconductor crystal 12 can be suppressed. In the case where group III nitride semiconductor crystal 12 is grown at the temperature of 1200°C or lower, degradation in crystallinity can be further suppressed.

The partial pressure of silicon tetrafluoride in growing group III nitride semiconductor crystal 12 is preferably at least 2.0 × 10⁻⁷ atm and not more than 1.0 × 10⁻⁵ atm. In the case where the partial pressure of silicon tetrafluoride is 2.0 × 10⁻⁷ atm, silicon qualified as the n type dopant can be taken in group III nitride semiconductor crystal 12 sufficiently. In the case where the partial pressure of silicon tetrafluoride is not more than 1.0 × 10⁻⁵ atm, silicon can be doped with higher controllability since the generation of an SiₓN_{y} (silicon nitride) type compound can be further suppressed. In consideration of the concentration of silicon doped into group III nitride semiconductor crystal 12, the partial pressure of silicon tetrafluoride is not more than 1.0 × 10⁻⁵ atm. The total of respective partial pressures (entirety) of each of the raw material gas, carrier gas, doping gas, and the like in reaction tube 110 is 1 atm. The concentration of silicon tetrafluoride gas is proportional to the partial pressure.

By adjusting the flow rate of first raw material gas G1, the flow rate of second raw material gas G3, or the amount of the raw material in source boat 107, the thickness of the group III nitride semiconductor crystal to be grown can be modified appropriately. Group III nitride semiconductor crystal 12 is preferably grown such that the thickness D12 thereof is at least 100 µm and not more than 1100 µm, for example. By virtue of the high crystal growing rate in HVPE, a group III nitride semiconductor crystal 12 having a large thickness can be grown by controlling the growing time. In the case where thickness D12 is at least 100 µm, a group III nitride semiconductor crystal 12 that can be employed singularly as the substrate for various types of semiconductor devices can be grown readily. By setting thickness D12 to 1100 µm at most, a group III nitride semiconductor crystal substrate 10 having the aforementioned thickness D 10 can be obtained by the step of removing at least underlying substrate 11 (step S3) that will be described afterwards.

At the growing step (step S2), the doping gas is supplied to underlying substrate 11 such that the concentration of silicon in group III nitride semiconductor crystal 12 is preferably at least 5 × 10¹⁶cm⁻³ and not more than 5 × 10²⁰cm⁻³, more preferably at least 3 × 10¹⁸cm⁻³ and not more than 5 × 10¹⁹cm⁻³. In the case where the silicon concentration is at least 5 × 10¹⁶cm⁻³, the concentration of silicon taken in group III nitride semiconductor crystal 12 can be readily controlled by adjusting the concentration of doping gas G2. In the case where the silicon concentration is at least 3 × 10¹⁸cm⁻³, the concentration of silicon taken in group III nitride semiconductor crystal 12 can be readily controlled. In the case where the silicon concentration is not more than 5 × 10²⁰cm⁻³, generation of a pit or defect, as well as generation of a crack, at group III nitride semiconductor crystal 12 during growth, can be suppressed. In the case where the silicon concentration is 5 × 10¹⁹cm⁻³ at most, generation of a pit or defect at group III nitride semiconductor crystal 12, as well as generation of a crack, can be suppressed.

In the growing step (step S2), group III nitride semiconductor crystal 12 is grown such that the resistivity is at least 1 × 10⁻⁴ Ω·cm and not more than 0.1 Ω·cm, preferably at least 1 × 10⁻³ Ω·cm and not more than 1 × 10⁻² Ω·cm, more preferably at least 1 × 10⁻³Ω·cm and not more than 8 × 10⁻³Ω·cm. In the case where the resistivity is at least 1 × 10⁻⁴Ω·cm, silicon does not have to be doped in high concentration. Therefore, group III nitride semiconductor crystal 12 rendered fragile due to impurities being taken in can be suppressed. As a result, a group III nitride semiconductor crystal 12 can be grown having generation of a pit or defect, as well as a crack suppressed. In the case where the resistivity is at least 1 × 10⁻³ Ω·cm, a group III nitride semiconductor crystal 12 further suppressed in the generation of a pit, defect and crack can be grown. In the case where the resistivity is not more than 0.1 Ω·cm, a group III nitride semiconductor crystal 12 that can be conveniently employed for an electronic device or light emitting device can be grown. In the case where the resistivity is 1 × 10⁻² Ω·cm at most, a group III nitride semiconductor crystal 12 conveniently selected for an electronic device or light emitting device, particularly a power device, can be grown. In the case where the resistivity is not more than 8 × 10⁻³ Ω·cm, a group III nitride semiconductor crystal 12 further conveniently selected for an electronic device or light emitting device, particularly a power device, can be grown.

In addition, group III nitride semiconductor crystal 12 is grown such that the resistivity distribution in the diameter direction is at least -20% and not more than 20%, preferably at least -5% and not more than 5%. The range of-20% to 20% is advantageous in that, when devices are produced using the crystal, variation of the performance in the diameter direction can be suppressed and the yield improved. The range of-5% to 5% is advantageous in that, when devices are produced using the crystal, variation of the performance can be suppressed and the yield improved.

Group III nitride semiconductor crystal 12 is grown such that the resistivity distribution in the thickness direction is at least -10% and not more than 10%, preferably at least-3% and not more than 3%. The range of-10% to 10% is advantageous in that group III nitride semiconductor crystal 12 is grown such that, when devices are produced using the crystal, variation of the performance in the thickness direction can be suppressed and the yield improved. The range of-3% to 3% is advantageous in that, group III nitride semiconductor crystal 12 is grown such that, when devices are produced using the crystal, variation of the performance is suppressed and the yield improved.

Preferably in the growing step (step S2), group III nitride semiconductor crystal 12 is an AlₓIn_{y}Ga_{(1-x-y)}N (0≤x≤1, 0≤y≤1, x+y≤1) crystal, preferably a gallium nitride crystal. Accordingly, an extremely effective first group III nitride semiconductor crystal can be grown.

In the growing step (step S2), the doping gas is supplied to underlying substrate 11 such that the concentration of oxygen in group III nitride semiconductor crystal 12 is not more than 5 × 10¹⁶ cm⁻³. Although gas containing oxygen is not employed as doping gas in the present embodiment, the oxygen in reaction tube 110 will be taken into the growing group III nitride semiconductor crystal 12. Although oxygen is an n type dopant, identical to silicon, the efficiency of being taken into the c-plane is poor. Particularly, the introduction efficiency differs depending upon the plane orientation. Oxygen is known to have poor controllability as an n type dopant. By preventing the introduction of oxygen down to the concentration of not more than 5 × 10¹⁶cm⁻³, more preferably down to the concentration of not more than 2 × 10¹⁶cm⁻³, the resistivity of group III nitride semiconductor crystal 12 can be controlled stably. Although the oxygen concentration is preferably as low as possible, the lower limit is 5 × 10¹⁵cm⁻³ or above in consideration of the lowest measurable level for detection in SIMS analysis.

In the growing step (step S2), group III nitride semiconductor crystal 12 is grown such that the dislocation density of group III nitride semiconductor crystal 12 is preferably not more than 1 × 10⁷cm⁻², more preferably not more than 1 × 10⁶cm⁻². A dislocation density of not more than 1 × 10⁷cm⁻² is advantageous in that, when employed in an electronic device, the electric property can be improved, and when employed in an optical device, the optical property can be improved. A group III nitride semiconductor crystal 12 of more favorable property can be obtained. In the case where the dislocation density is not more than 1 × 10⁶cm⁻², the performance in usage of a semiconductor device can be further improved. Although the dislocation density is preferably as low as possible, the lower limit is, for example, at least 1 × 10³cm⁻². In the case where the dislocation density is at least 1 × 10³cm⁻², a group III nitride semiconductor crystal 12 can be produced at low cost.

In the growing step (step S2), group III nitride semiconductor crystal 12 is grown such that the main face of group III nitride semiconductor crystal 12 is preferably at the angle of at least -5 degrees and not more than 5 degrees relative to any one of a (0001) plane, (1-100) plane, (11-20) plane and (11-22) plane. A group III nitride semiconductor crystal of favorable crystallinity can be additionally grown on the main face. Therefore, the usage thereof in an electronic device and a light emitting device allows improvement in the electric property and optical property, respectively. A semiconductor device of further favorable property can be obtained.

In the growing step (step S2), group III nitride semiconductor crystal 12 is grown such that the full width at half maximum of a rocking curve in the X-ray diffraction is preferably at least 10 arcsec and not more than 500 arcsec, more preferably at least 20 arcsec and not more than 100 arcsec. The value of not more than 500 arcsec is advantageous in that a semiconductor device of further favorable property is obtained since a group III nitride semiconductor crystal of favorable crystallinity can be further grown on group III nitride semiconductor crystal 12. In the case where the value is not more than 100 arcsec, a group III nitride semiconductor crystal of further favorable crystallinity can be additionally grown thereon. In the case where the value is at least 10 arcsec, the cost can be reduced since a group III nitride semiconductor crystal 12 can be readily grown. The cost can be further reduced in the case where the value is at least 20 arcsec.

Then, the heating by heater 109 is stopped, and the temperature of source boat 107, group III nitride semiconductor crystal 12, and underlying substrate 11 is reduced down to approximately the room temperature. Then, underlying substrate 11 and group III nitride semiconductor crystal 12 are taken out from reaction tube 110.

Thus, group III nitride semiconductor crystal 12 can be grown on underlying substrate 11 shown in Fig. 4.

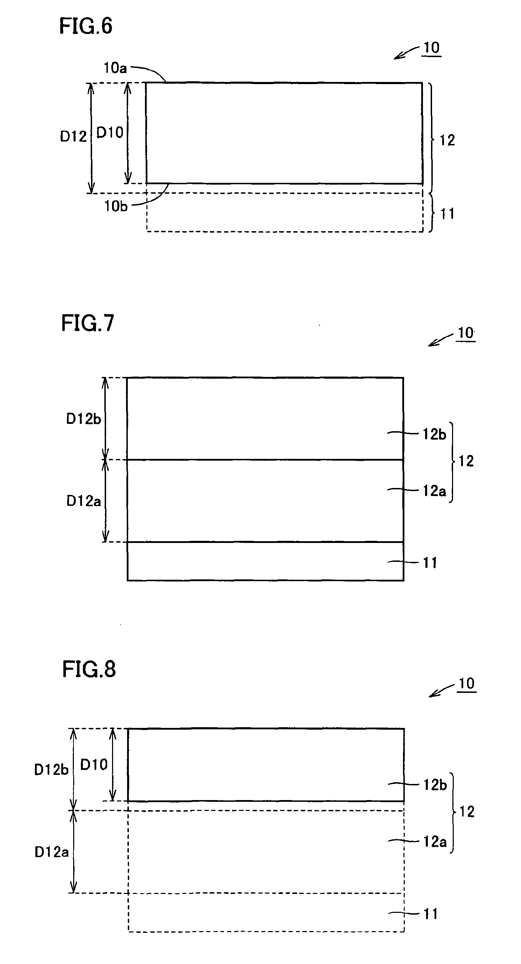

A fabrication method of a group III nitride semiconductor crystal substrate 10 of the present embodiment will be described hereinafter with reference to Fig. 6.

Referring to Fig. 6, at least underlying substrate 11 is removed to produce a group III nitride semiconductor crystal substrate 10 constituted of group III nitride semiconductor crystal 12 having a thickness D10 of at least 100 µm (step S3).

The crystallinity is often not favorable in the neighborhood of the interface between group III nitride semiconductor crystal 12 and underlying substrate 11. It is therefore preferable to fabricate a group III nitride semiconductor crystal substrate 10 by further removing the region of group III nitride semiconductor crystal 12 where the crystallinity is not favorable. Thus, group III nitride semiconductor crystal substrate 10 having a main face 10a and a face 10b opposite to main face 10a is produced, as shown in Fig. 6.

The removing method includes the method of, for example, cutting, grinding, and the like. Cutting refers to dividing (slicing) mechanically at least underlying substrate 11 from group III nitride semiconductor crystal 12 by means of a slicer having a peripheral cutting edge of a diamond electrolytic deposited wheel or a wire saw. Grinding refers to mechanically grinding away at least underlying substrate 11 by a grinding equipment with a diamond grindstone.

The face to be removed from group III nitride semiconductor crystal 12 is not limited to a face parallel to the surface of underlying substrate 11. For example, a face having an arbitrary inclination with respect to the surface may be sliced. It is to be noted that main face 10a preferably has an angle of at least -5 degrees and not more than 5 degrees relative to any one of a (0001) plane, (1-100) plane, (11-20) plane and (11-22) plane, as set forth above.

Main face 10a and opposite face 10b of group III nitride semiconductor crystal substrate 10 may be further subjected to polishing or surface treatment. The polishing method or the surface treatment method is not particularly limited, and an arbitrary method may be employed.

By carrying out the steps set forth above (steps S1-S3), a group III nitride semiconductor crystal substrate 10 shown in Figs. 1 and 2 can be fabricated. Namely, there is obtained a group III nitride semiconductor crystal substrate 10 having a resistivity of at least 1 × 10⁻⁴ Ω·cm and not more than 0.1 Ω·cm, a resistivity distribution in the diameter direction of at least -20% and not more than 20%, and a resistivity distribution in the thickness direction of at least -10% and not more than 10%.

### First Modification

A fabrication method of a group III nitride semiconductor crystal substrate according to a first modification of the present embodiment will be described hereinafter with reference to Figs. 7 and 8.

As shown in Fig. 7, the growing method of a group III nitride semiconductor crystal substrate of the present modification is basically similar to that of the first embodiment set forth above, and differs in that two layers of group III nitride semiconductor crystal are grown at the growing step (step S2).

Specifically, as shown in Fig. 7, group III nitride semiconductor crystal 12 doped with silicon by using silicon tetrafluoride as the doping gas provided on underlying substrate 11 by vapor phase growth is a first group III nitride semiconductor crystal 12a. Then, a second group III nitride semiconductor crystal 12b doped with silicon by using silicon tetrafluoride as the doping gas is grown in a similar manner on first group III nitride semiconductor crystal 12a. Thus, there are produced underlying layer 11, first group III nitride semiconductor crystal 12a on underlying substrate 11, and second group III nitride semiconductor crystal 12b on first group III nitride semiconductor crystal 12a.

Then, at least underlying substrate 11 is removed, as shown in Fig. 8, to fabricate a group III nitride semiconductor crystal substrate constituted of at least one of first and second group III nitride semiconductor crystals 12a and 12b having a thickness of D10 of at least 100 µm. In the present modification, a group III nitride semiconductor crystal substrate constituted of second group III nitride semiconductor crystal 12b is fabricated by removing first group III nitride semiconductor crystal 12a and a portion of second group III nitride semiconductor crystal 12b. In this case, a group III nitride semiconductor crystal substrate 10 of further favorable crystallinity can be obtained by taking first group III nitride semiconductor crystal 12a as a buffer layer directed to matching with underlying substrate 11 in the lattice constant, and growing second group III nitride semiconductor crystal 12b of further favorable crystallinity thereon.

### Second Modification

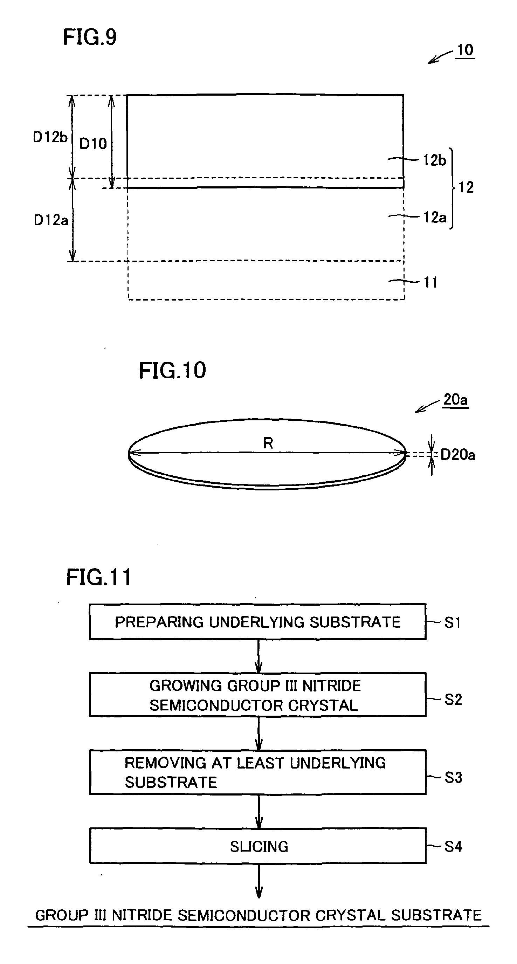

A fabrication method of a group III nitride semiconductor crystal substrate according to a second modification of the present embodiment will be described hereinafter with reference to Fig. 9.

As shown in Fig. 9, the growing method of a group III nitride semiconductor crystal of the present modification is similar to that of the first modification. The fabrication method of a group III nitride semiconductor crystal substrate of the present modification is basically similar to the fabrication method of a group III nitride semiconductor crystal of the first modification, and differs in that a group III nitride semiconductor crystal substrate 10 including first and second group III nitride semiconductor crystals 12a and 12b is fabricated by removing a portion of first group III nitride semiconductor crystal 12a in the step of removing at least the underlying substrate (step S3).

In group III nitride semiconductor crystal substrate 10 of the present modification, the two layers of group III nitride semiconductor crystals 12a and 12b may be of the same composition or of different compositions. Furthermore, the growing method of a group III nitride semiconductor crystal of the present invention is not particularly limited to the method of growing one or two layers of group III nitride semiconductor crystal. Three or more layers of a group III nitride semiconductor crystal may be grown.

As set forth above, the growing method of a group III nitride semiconductor crystal 12 in the present embodiment and modifications thereof includes the step of growing a group III nitride semiconductor crystal doped with silicon by using silicon tetrafluoride gas as the doping gas, on underlying substrate 11 by vapor phase growth (step S2).

According to the growing method of a group III nitride semiconductor crystal of the present embodiment and modifications thereof, silicon tetrafluoride gas is used as the doping gas in growing a group III nitride semiconductor crystal 12 doped with silicon.

Silicon tetrafluoride gas is characterized in that, as compared to other doping gases directed to doping silicon, the gas per se is not readily decomposed, and does not easily react with another gas such as the raw material gas for the group III nitride semiconductor crystal and the carrier gas. Particularly, it is to be noted that silane, disilane, chlorosilane, dichlorosilane, monochlorosilane and tetrachlorosilane react with ammonia gas that is the raw material of nitrogen (N) at a temperature in the vicinity of the room temperature, whereas silicon tetrafluoride gas does not react with ammonia gas even if raised up to 1200°C. Therefore, the event of the silicon tetrafluoride gas being decomposed prior to arrival at underlying substrate 11 to adhere to a region other than underlying substrate 11 and/or generation of an SiₓN_{y} (silicon nitride) type compound (x and y are arbitrary integers) caused by the reaction of silicon in the silicon tetrafluoride can be suppressed. Accordingly, control over the concentration of tetrafluoride gas qualified as the doping gas allows the concentration of silicon serving as the dopant to be controlled readily. As a result, the amount of silicon taken in group III nitride semiconductor crystal 12 can be regulated at a constant level. Thus, the resistivity of group III nitride semiconductor crystal 12 can be readily controlled.

Since the amount of silicon in the silicon tetrafluoride gas can be controlled readily, it is not necessary to supply the silicon tetrafluoride gas to underlying substrate 11 at a high rate. Accordingly, first group III nitride semiconductor crystal 12 can be grown with the doping gas supplied at an appropriate rate, and the doping gas can be supplied uniformly to underlying substrate 11. Therefore, degradation in the resistivity in-plane distribution of group III nitride semiconductor crystal 12 to be grown can be prevented.

Even if hydrogen fluoride (HF) having intense corrosion is generated by the reaction of silicon tetrafluoride with hydrogen in the case where the carrier gas contains hydrogen or with the hydrogen in the reaction tube, the generated amount of hydrogen fluoride is not enough to damage the reaction tube, when silicon tetrafluoride is employed as the doping gas, since the ratio employed to the entire gas is extremely low. Therefore, damage at the reaction tube due to silicon tetrafluoride gas can be prevented in the present embodiment and modifications thereof.

The fabrication method of a group III nitride semiconductor crystal substrate 10 of the present embodiment and modifications thereof includes the step of removing at least underlying substrate 11 to form a group III nitride semiconductor crystal substrate 10 constituted of group III nitride semiconductor crystal 12 having a thickness D 10 of at least 100 pm (step S3).

Since group III nitride semiconductor crystal substrate 10 of the present embodiment and modifications thereof can be obtained by the fabrication method of a group III nitride semiconductor crystal substrate 10 set forth above, the resistivity is at least 1 × 10⁻⁴Ω·cm and not more than 0.1 Ω·cm, the resistivity distribution in the diameter direction is at least -20% and not more than 20%, and the resistivity distribution in the thickness direction is at least -10% and not more than 10%.

Since the resistivity of group III nitride semiconductor crystal substrate 10 constituted of group III nitride semiconductor crystal 12 grown with silicon tetrafluoride gas as doping gas can be adjusted, group III nitride semiconductor crystal substrate 10 has a low resistivity in the range set forth above. Since group III nitride semiconductor crystal 12 is grown by supplying doping gas at an appropriate flow rate for growth, the resistivity distribution in the diameter direction and thickness direction can be set to a low level as in the ranges set forth above. Thus, variation in both the diameter direction and thickness direction can be suppressed.

### Second Embodiment

A group III nitride semiconductor crystal substrate according to a second embodiment will be described with reference to Fig. 10.

As shown in Fig. 10, a group III nitride semiconductor crystal substrate 20a of the second embodiment is basically similar to group III nitride semiconductor crystal substrate 10 of the first embodiment shown in Fig. 1. The difference lies in that thickness D20a is at least 100 µm and not more than 1000 µm.

Thickness D20a of group III nitride semiconductor crystal substrate 20a is at least 100 µm and not more than 1000 µm, preferably at least 60 µm and not more than 300 µm. In the case where thickness D20 is at least 100 µm, there can be obtained a group III nitride semiconductor crystal substrate 20a having generation of a crack during handling prevented. In the case where thickness D20a is at least 60 µm, a group III nitride semiconductor crystal substrate 20a having generation of a crack further prevented is obtained. In the case where thickness D20a is not more than 1000 µm, the substrate can be conveniently employed for devices. The fabrication cost per one group III nitride semiconductor crystal substrate 20a can be reduced. In the case where thickness D20a is not more than 300 µm, the fabrication cost per one group III nitride semiconductor crystal substrate 20a can be further reduced.

As used herein, " resistivity distribution in the thickness direction" refers to a value measured by a method set forth below. Specifically, the resistivity is measured at each site of the total of 2 points at respective arbitrary thickness, i.e. one point in the proximity of main face 10a, and one point in the proximity of a face 10b opposite to main face 10a, by the four probe method at room temperature. The average of the 2 values of resistivity is calculated. With regards to the values of resistivity at the 2 points, the value defined by (largest value - average value)/average value is taken as the upper limit of the resistivity distribution in the diameter direction, and the value defined by (smallest value - average value)/average value is taken as the lower limit of the resistivity distribution in the diameter direction.

Hereinafter, a fabrication method of a group III nitride semiconductor crystal according to the present embodiment will be described hereinafter with reference to Fig. 11.

As shown in Fig. 11, a group III nitride semiconductor crystal 12 is grown according to the growing method of group III nitride semiconductor crystal 12 (steps S1, S2) of the first embodiment set forth above. Then, at least underlying substrate 11 is removed (step S3), likewise with the first embodiment. Accordingly, a group III nitride semiconductor crystal substrate 10 of the first embodiment is fabricated.

Then, group III nitride semiconductor crystal 12 is sliced in the thickness direction to produce a plurality of group III nitride semiconductor crystal substrates 20a-20m constituted of a group III nitride semiconductor crystal 12 having a thickness of at least 100 µm and not more than 1000 µm (step S4).

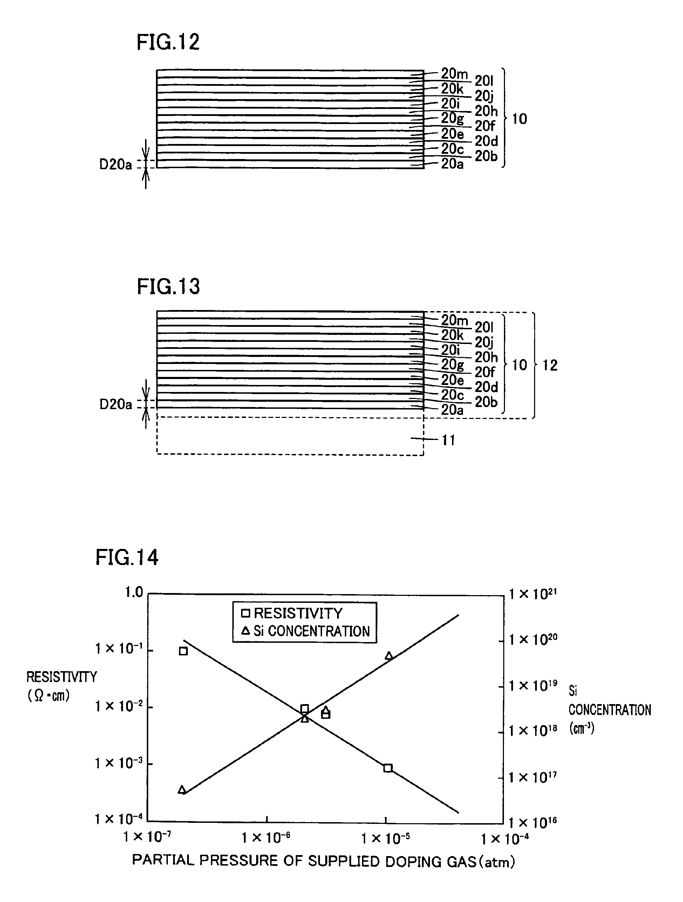

As shown in Fig. 12, group III nitride semiconductor crystal substrate 10 is worked into a plurality of group III nitride semiconductor crystal substrates 20a-20m having a desired thickness. The slicing method is not particularly limited, and a slicer having an outer peripheral edge of a diamond electrolytic deposited wheel, a wire saw or the like may be used.

### Modification

A fabrication method of a group III nitride semiconductor crystal substrate of the present modification is basically similar to the fabrication method of a group III nitride semiconductor crystal substrate of the second embodiment, provided that the order of the steps differs, as shown in Fig. 13.

Specifically, by carrying out a growing method of a group III nitride semiconductor crystal substrate in a manner similar to that of the first embodiment, a group III nitride semiconductor crystal 12 is grown on underlying substrate 11. Then, by slicing group III nitride semiconductor crystal 12 in the thickness direction, a plurality of group III nitride semiconductor crystal substrates 20a-20m constituted of group III nitride semiconductor crystal 12 having a thickness of at least 100 µm and not more than 1000 µm are produced (step S4). As a result, at least underlying substrate 11 is removed from group III nitride semiconductor crystal 12 (step S3). Namely, group III nitride semiconductor crystal substrates 20a-20m are sliced prior to the removal of underlying substrate 11.

The fabrication method of a group III nitride semiconductor crystal substrate 20a according to the present embodiment and modification thereof includes the step of slicing group III nitride semiconductor crystal substrate 10 of the first embodiment in the thickness direction (step S4).

Since group III nitride semiconductor crystal substrate 20a of the present embodiment and modification thereof is obtained by the fabrication method of group III nitride semiconductor crystal substrate 20a set forth above, the resistivity is at least 1 × 10⁻⁴ Ω·cm and not more than 0.1 Ω·cm, the resistivity distribution in the diameter direction is at least -20% and not more than 20%, and the resistivity distribution in the thickness direction is at least -10% and not more than 10%.

According to the fabrication method of a group III nitride semiconductor crystal substrate 20a of the present embodiment and modification thereof, group III nitride semiconductor crystal 12 doped with silicon using silicon tetrafluoride as the doping gas is produced. Since the resistivity of group III nitride semiconductor crystal substrate 20a can be readily adjusted, group III nitride semiconductor crystal substrate 20a has a low resistivity in the range set forth above. Further, since doping gas is supplied at an appropriate flow rate, the resistivity distribution in the diameter direction and thickness direction can be set to a low level in the ranges set forth above. Thus, variation in both the diameter direction and thickness direction can be suppressed.

Group III nitride semiconductor crystal 12 obtained by the growing method of a group III nitride semiconductor crystal and group III nitride semiconductor crystal substrates 10 and 20a-20m obtained by the fabrication method of a group III nitride semiconductor crystal substrate according to the first and second embodiments and modifications thereof set forth above can have the resistivity readily controlled and degradation in the resistivity in-plane distribution prevented. Therefore, group III nitride semiconductor crystal 12 and group III nitride semiconductor crystal substrates 10a and 20a-20m can be conveniently selected for a substrate and the like in optical devices such as a light emitting diode and laser diode, electronic devices such as a rectifier, bipolar transistor, field effect transistor, and HEMT, semiconductor sensors such as a temperature sensor, pressure sensor, radiation sensor, and visible-ultraviolet photodetector, as well as a SAW device, transducer, oscillator, MEMS component, and piezoactuator. Such devices can be fabricated by stacking a semiconductor layer and metal layer on such group III nitride semiconductor crystal 12a and group III nitride semiconductor crystal substrates 10a and 20a-20m.

Although thicknesses D 10, D20a and diameter R of group III nitride semiconductor crystal 12 to be grown are set in the ranges set forth above in the first embodiment, first and second modifications thereof, second embodiment, and a modification thereof, the other conditions are not particularly limited as long as group III nitride semiconductor crystal 12 to be grown in the present invention has silicon doped by silicon tetrafluoride gas. The number of sample sites to be measured for the resistivity distribution in the thickness direction corresponds to 5 points in the case where the thickness of group III nitride semiconductor crystal 12 or group III nitride semiconductor crystal substrate 10 is at least 2 mm, and corresponds to 2 points in the case where the thickness of group III nitride semiconductor crystal 12 is less than 2 mm.

### EXAMPLES

In the present examples, the effect of growing a group III nitride semiconductor crystal doped with silicon by using silicon tetrafluoride gas on an underlying substrate through vapor phase growth was evaluated. Specifically, group III nitride semiconductor crystal substrates of Specimens 1-10 were fabricated according to the second embodiment. The resistivity, the resistivity distribution in the diameter direction and thickness direction, and the silicon concentration were measured. Moreover, the surface state was observed.

### [Specimens 1-5]

First, an underlying substrate 11 formed of gallium nitride having a diameter of 105 mm and a thickness of 400 µm was prepared (step S1). The main face of underlying substrate 11 corresponds to the (0001) plane.

Then, a gallium nitride crystal was grown as a group III nitride semiconductor crystal doped with silicon by using silicon tetrafluoride gas as doping gas, on underlying substrate 11 by HVPE as the vapor phase growth (step S2).

At step S2, the gallium nitride crystal was grown using the HVPE apparatus of Fig. 5. Ammonia gas and hydrogen chloride gas were prepared as first raw material gas G1 and second raw material gas G3, respectively. Silicon tetrafluoride gas was prepared as doping gas G2. Hydrogen having the purity of at least 99.999% was prepared as carrier gas. Carrier gas was introduced into reaction tube 110 from each of first gas introduction pipe 104, second gas introduction pipe 106, and doping gas introduction pipe 105. The temperature of heater 109 was raised to 1100°C. Then, gallium was supplied to source boat 107, and source boat 107 was heated.

GaCl (gallium chloride) gas was generated as reaction gas G7 by the reaction of hydrogen chloride gas supplied from second gas introduction pipe 106 with the gallium on source boat 107, as expressed by Ga+HCl→GaCl+1/2H₂.

Then, ammonia gas that is first raw material gas G1 supplied from first gas introduction pipe 104 and gallium chloride gas were delivered together with the carrier gas to strike the surface of underlying substrate 11 where a gallium nitride crystal is to be grown, causing the reaction of GaCl+NH₃→GaN+HCl+H₂ at the surface.

The conditions for growing a gallium nitride crystal including the partial pressure and the flow rate of supplying doping gas were as set forth in Table 1. Thus, group III nitride semiconductor crystal 12 formed of a gallium nitride crystal having a diameter of 105 mm and a thickness of 10 mm was grown.

Then, the underlying substrate was removed from the gallium nitride crystal identified as group III nitride semiconductor crystal 12 (step S3). The crystal was sliced in the thickness direction (step S4). Then, working steps such as grinding, polishing, dry etching, and the like were applied to remove the denatured layer. Thus, thirteen group III nitride semiconductor crystal substrates formed of gallium nitride crystal having a diameter of 100 mm and a thickness of 400 µm were obtained. Among the thirteen group III nitride semiconductor crystal substrates, the group III nitride semiconductor crystal substrate (group III nitride semiconductor crystal substrate 20g in Fig. 12) located at the middle in the thickness direction was taken as the group III nitride semiconductor crystal substrate for Specimens 1-5.

### [Specimens 6-10]

Specimens 6-10 were obtained by growing a gallium nitride crystal basically in a manner similar to that of Specimens 1-5, differing in the doping gas. Specifically, the doping gas set forth in Table 1 was employed in the growing step (step S2), according to the partial pressure and flow rate set forth in Table 1.

### [Measurement Method]

The resistivity, resistivity distribution in the thickness direction, resistivity distribution in the diameter direction, and the silicon concentration were measured by the methods set forth below for the gallium nitride crystal substrates of Specimens 1-10. The results are shown in Table 1.

The surface of the group III nitride semiconductor crystal substrate of Specimens 1-10 was mirror-polished, and any damage layer caused by polishing was removed by dry etching at the main face. Then, the resistivity was measured at each site of the total of 9 points , i.e. 5 points along a given diameter including one point around the center, two points around either ends, and respective intermediate points between the center and either end (two points), and 4 points along a diameter orthogonal to the given diameter including two points around either ends and respective intermediate points between the center and either end (two points), by the four probe method at room temperature. The average of the nine points was taken as the resistivity. The value defined by (largest value - average value)/average value was taken as the upper limit of the resistivity distribution in the diameter direction, and the value defined by (smallest value - average value)/average value was taken as the lower limit of the resistivity distribution in the diameter direction. In Table 1, "<±15" refers to the range from -15% to 15%.

The resistivity distribution in the thickness direction is a value measured by a method set forth below. Likewise with the above-described method, the top face and bottom face of the group III nitride semiconductor crystal substrate were subjected to surface polishing and dry etching. The resistivity was measured at each site of the total of 2 points, i.e. one point in the proximity of the main face, and one point in the proximity of the face opposite to the main face, by the four probe method at room temperature. The average of the 2 values of resistivity was calculated. With regards to the values of resistivity at the 2 points, the value defined by (largest value - average value)/average value was taken as the upper limit of the resistivity distribution in the thickness direction, and the value defined by (smallest value - average value)/average value was taken as the lower limit of the resistivity distribution in the thickness direction. In Table 1, "< ±7" refers to the range of -7% to 7%.

The silicon concentration was measured based on the specimens directed to the 9-point measurement employed for measuring the resistivity. The specimen was cut into 5 mm square. The silicon concentration of the cut measurement specimen was measured by SIMS. The average thereof was taken as the average value of the silicon concentration.

The surface state of the main face of the gallium nitride crystal substrate of Specimens 1-10 was observed through a Nomarski microscope.

Furthermore, by growing the gallium nitride crystal of Specimens 1-10, observation was made as to whether corrosion has occurred in the reaction tube by visual confirmation.

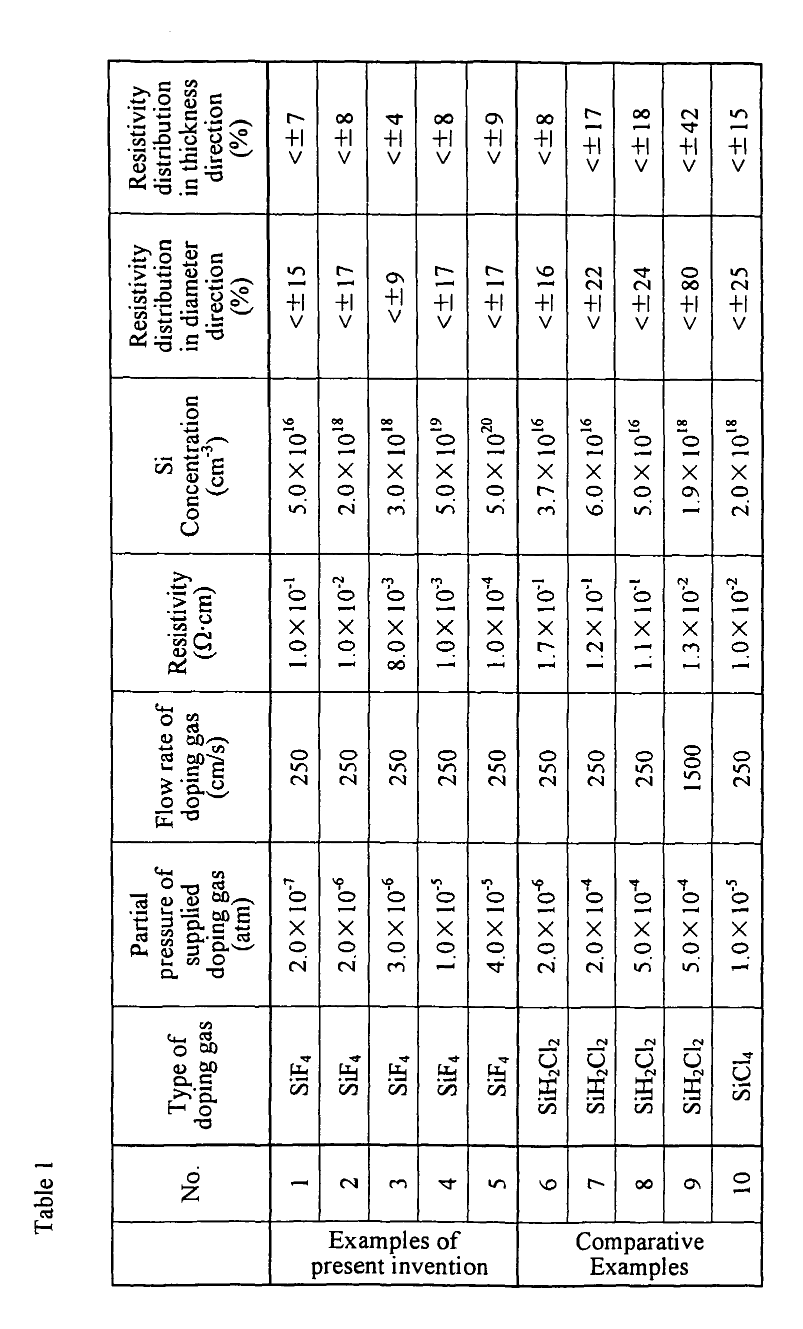

### [Measurement Results]

It is appreciated from Table 1 that the gallium nitride crystal substrates of Specimens 1-5 based on the grown gallium nitride crystal using silicon tetrafluoride gas as doping gas had a low resistivity of at least 1 × 10⁻⁴ Ω·cm and not more than 0.1 Ω·cm, low variation of the resistivity distribution in the diameter direction of at least -17% and not more than 17%, low variation of the resistivity distribution in the thickness direction of at least -9% and not more than 9%, and a high silicon concentration of at least 5 × 10¹⁶cm⁻³ and not more than 5 × 10²⁰cm⁻³.

In Fig. 14, the horizontal axis represents the partial pressure of the supplied silicon tetrafluoride gas in growing a gallium nitride crystal for Specimens 1-5 (unit: atm); the left vertical axis represents the resistivity of the gallium nitride crystal substrate of Specimens 1-5 (unit: Ω·cm); and the right vertical axis represents the silicon concentration of the gallium nitride crystal substrate of Specimens 1-5 (unit: cm⁻³). It is appreciated from Fig. 14 that increase in the partial pressure of silicon tetrafluoride gas (increasing the concentration of silicon tetrafluoride gas) causes a higher concentration of silicon taken in the grown gallium nitride crystal, and reduction in resistivity.

It was observed that no corrosion occurred in the reaction tube in the fabrication of the gallium nitride crystal substrate of Specimens 1-5. It was therefore appreciated that the reaction of the silicon tetrafluoride gas to hydrogen fluoride was suppressed, or lowered to a level that will not affect the reaction tube even if reaction occurs.

In contrast, Specimens 6-8 based on the usage of dichlorosilane as the doping gas exhibited a high resistivity exceeding 0.1 Ω·cm. Specimens 7 and 8 exhibited a resistivity distribution in the diameter direction exceeding the range of-20% to 20% and a resistivity distribution in the thickness direction exceeding the range of-10% to 10%. As a matter of logic, the resistivity and silicon concentration in the grown gallium nitride crystal should be identical between Specimen 6 and Specimen 2 since the partial pressure of the doping gas was the same. However, Specimen 6 based on the usage of dichlorosilane as the doping gas exhibited a resistivity higher than that of Specimen 2 and a silicon concentration lower than that of Specimen 2 in the gallium nitride crystal substrate. It was therefore appreciated from such results that the silicon dopant could not be taken into the growing gallium nitride crystal sufficiently when dichlorosilane is used as the doping gas due to the decomposition of dichlorosilane and reaction with another gas.

Specimen 9 based on the usage of dichlorosilane as a doping gas and having the flow rate of the doping gas increased to reduce the resistivity exhibited a great resistivity distribution in the diameter direction and thickness direction although the resistivity was reduced. Variation in the in-plane resistivity was great.

The gallium nitride crystal substrate of Specimen 10 was grown using tetrachlorosilane as the doping gas. The decomposition of tetrachlorosilane at 1100°C and reaction with the raw material gases and carrier gas are lower than those of dichlorosilane. As compared to Specimens 1-5 based on the usage of silicon tetrafluoride gas as the doping gas, Specimen 10 exhibited a resistivity distribution in the diameter direction exceeding the range of-20% to 20% and a resistivity distribution in the thickness direction exceeding the range of-10% to 10%.

The surface state of the gallium nitride crystal substrates of Specimens 1-10 was flat with almost no unevenness observed.

Thus, it was confirmed by the present examples of the present invention that a group III nitride semiconductor crystal can be grown, allowing the resistivity to be readily controlled and preventing degradation in the resistivity in-plane distribution by using silicon tetrafluoride gas as the doping gas. It was also confirmed that corrosion in the reaction tube does not occur even if silicon tetrafluoride gas is used as the doping gas. It was confirmed that using silicon tetrafluoride gas as the doping gas is particularly suitable for growing a group III nitride semiconductor crystal based on a silicon dopant through HVPE.

Although a gallium nitride crystal was grown as the group III nitride semiconductor crystal in the present examples, it was also confirmed that a similar result can be obtained based on a group III nitride semiconductor crystal of another type (group III nitride semiconductor crystal including at least one element of a group III element of B (boron), Al (aluminium), Ga (gallium), In (indium) and Tl (thallium).

A group III nitride semiconductor crystal obtained by the growing method of a group III nitride semiconductor crystal and a group III nitride semiconductor crystal substrate obtained by the fabrication method of a group III nitride semiconductor crystal substrate according to the present invention can have the resistivity readily controlled and degradation in the resistivity in-plane distribution prevented. Therefore, the group III nitride semiconductor crystal and the group III nitride semiconductor crystal substrate can be conveniently selected for a substrate and the like in optical devices such as a light emitting diode and laser diode, electronic devices such as a rectifier, bipolar transistor, field effect transistor, and HEMT, semiconductor sensors such as a temperature sensor, pressure sensor, radiation sensor, and visible-ultraviolet photodetector, as well as a SAW device, transducer, oscillator, MEMS component, and piezoactuator.

Although the present invention has been described and illustrated in detail, it is clearly understood that the same is by way of illustration and example only and is not to be taken by way of limitation, the scope of the present invention being interpreted by the terms of the appended claims.

## Claims

1. A growing method of a group III nitride semiconductor crystal, comprising the steps of:
preparing (S1) an underlying substrate (11), and
growing (S2) a first group III nitride semiconductor crystal (12, 12a) doped with silicon by using silicon tetrafluoride gas as doping gas, on said underlying substrate (11) by vapor phase growth.

2. The growing method of a group III nitride semiconductor crystal according to claim 1, wherein said growing step (S2) includes the step of growing said first group III nitride semiconductor crystal (12, 12a) by hydride vapor phase epitaxy.

3. The growing method of a group III nitride semiconductor crystal according to claim 2, wherein said growing step (S2) includes the step of growing said first group III nitride semiconductor crystal (12, 12a) at a temperature of at least 900°C and not more than 1300°C.

4. The growing method of a group III nitride semiconductor crystal according to claim 1, wherein said growing step (S2) includes the step of supplying said doping gas to said underlying substrate (11) such that a concentration of said silicon in said first group III nitride semiconductor crystal (12, 12a) is at least 5 × 10¹⁶cm⁻³ and not more than 5 × 10²⁰cm⁻³.

5. The growing method of a group III nitride semiconductor crystal according to claim 4, wherein said growing step (S2) includes the step of supplying said doping gas to said underlying substrate (11) such that a concentration of said silicon in said first group III nitride semiconductor crystal (12, 12a) is at least 3 × 10¹⁸ cm⁻³ and not more than 5 × 10¹⁹cm⁻³.

6. The growing method of a group III nitride semiconductor crystal according to claim 1, wherein said growing step (S2) includes the step of growing said first group III nitride semiconductor crystal (12, 12a) such that a resistivity is at least 1 × 10⁻⁴ Ω·cm and not more than 0.1 Ω·cm.

7. The growing method of a group III nitride semiconductor crystal according to claim 1, wherein said preparing step (S1) includes the step of preparing said underlying substrate (11) formed of a material including at least one type selected from the group consisting of silicon, sapphire, gallium arsenide, silicon carbide, gallium nitride and aluminium nitride.

8. The growing method of a group III nitride semiconductor crystal according to claim 1, wherein said preparing step (S1) includes the step of preparing a spinel type crystal substrate as said underlying substrate (11).

9. The growing method of a group III nitride semiconductor crystal according to claim 1, wherein said first group III nitride semiconductor crystal is an AlₓIn_{y}Ga_{(1-x-y)}N (0 ≤ x ≤ 1, 0 ≤ y ≤ 1, x + y ≤ 1) crystal.

10. The growing method of a group III nitride semiconductor crystal according to claim 1, wherein said first group III nitride semiconductor crystal (12, 12a) is a gallium nitride crystal.

11. The growing method of a group III nitride semiconductor crystal according to claim 1, wherein said growing step (S2) includes the step of supplying said doping gas to said underlying substrate (11) such that a concentration of oxygen in said first group III nitride semiconductor crystal (12, 12a) is not more than 5 × 10¹⁶cm⁻³.

12. The growing method of a group III nitride semiconductor crystal according to claim 1, further comprising the step of growing, on said first group III nitride semiconductor crystal (12a), a second group III nitride semiconductor crystal (12b) doped with silicon by using silicon tetrafluoride gas as doping gas.

13. A fabrication method of a group III nitride semiconductor crystal substrate, comprising the steps of:
growing (S1, S2) a group III nitride semiconductor crystal (12, 12a, 12b) on said underlying substrate (11) by the growing method of a group III nitride semiconductor crystal defined in claim 1, and
removing (S3) at least said underlying substrate (11) to form a group III nitride semiconductor crystal substrate (10, 20a - 20m) constituted of said group III nitride semiconductor crystal (12, 12a, 12b) having a thickness of at least 100 µm.

14. The fabrication method of a group III nitride semiconductor crystal substrate according to claim 13, further comprising the step of slicing (S4) said group III nitride semiconductor crystal (12, 12a, 12b) in a thickness direction to form a plurality of group III nitride semiconductor crystal substrates (10, 20a - 20m) constituted of a group III nitride semiconductor crystal (12, 12a, 12b) having a thickness of at least 100 µm and not more than 1000 µm.

15. A group III nitride semiconductor crystal substrate (10, 20a - 20m) fabricated by the fabrication method of a group III nitride semiconductor crystal defined in claim 13, having a diameter of at least 25 mm and not more than 160 mm, wherein
a resistivity is at least 1 × 10⁻⁴Ω·cm and not more than 0.1 Ω·cm,
a resistivity distribution in a diameter direction is at least -20% and not more than 20%, and
a resistivity distribution in a thickness direction is at least -10% and not more than 10%.

16. The group III nitride semiconductor crystal substrate (10) according to claim 15, having a thickness of at least 2 mm and not more than 160 mm.

17. The group III nitride semiconductor crystal substrate (20a - 20m) according to claim 15, having a thickness of at least 100 µm and not more than 1000 µm.

18. The group III nitride semiconductor crystal substrate (10, 20a - 20m) according to claim 15, wherein the resistivity is at least 1 × 10⁻³Ω·cm and not more than 8 × 10⁻³ Ω·cm.

19. The group III nitride semiconductor crystal substrate (10, 20a - 20m) according to claim 15, wherein a concentration of silicon is at least 5 × 10¹⁶cm⁻³ and not more than 5 × 10²⁰cm⁻³.

20. The group III nitride semiconductor crystal substrate (10, 20a - 20m) according to claim 15, wherein a concentration of silicon is at least 3 × 10¹⁸cm⁻³ and not more than 5 × 10¹⁹cm⁻³.

21. The group III nitride semiconductor crystal substrate (10, 20a - 20m) according to claim 15, wherein a dislocation density is not more than 1 × 10⁷cm⁻².

22. The group III nitride semiconductor crystal substrate (10, 20a - 20m) according to claim 15, wherein a main face (10a) has an angle of at least -5 degrees and not more than 5 degrees relative to any one of a (0001) plane, (1-100) plane, (11-20) plane and (11-22) plane.

23. The group III nitride semiconductor crystal substrate (10, 20a - 20m) according to claim 15, wherein a full width at half maximum of a rocking curve in X-ray diffraction is at least 10 arcsec and not more than 500 arcsec.
